# EUROPEAN PATENT APPLICATION

(11) **EP 2 525 410 A1**
(43) Date of publication of application: **21.11.2012**
(21) Application number: 11826363.1
(22) Date of filing: 11.07.2011
(51) Int. Cl.: H01L 29/739, H01L 29/06, H01L 21/331

(54) **INSULATED GATE BIPOLAR TRANSISTOR AND MANUFACTURING METHOD THEREOF**

(30) Priority: 25.09.2010 CN 201010290339
(71) Applicant: Zhejiang University, Xihu District Hangzhou Zhejiang 310058 (CN)
(72) Inventor: ZHANG, Bin, Hangzhou Zhejiang 310027 (CN); HAN, Yan, Hangzhou Zhejiang 310027 (CN); ZHANG, Shifeng, Hangzhou Zhejiang 310027 (CN); HU, Jiaxian, Hangzhou Zhejiang 310027 (CN)
(74) Representative: Gulde Hengelhaupt Ziebig & Schneider
(86) International application number: PCT/CN2011/077041
(87) International publication number: WO 2012/037836

(57) **Abstract**

The construction of an Insulated Gate Bipolar Transistor (IGBT) and its method of manufacturing are presented. The construction of IGBT consists of N-type base region, the P-type base region, back P-type anode, N-type cathode region, the gate oxide layer, an anode, a gate electrode and a cathode. The N-type base region includes the N+ diffusion remnant layer, N- base layer and N+ buffer layer. The doping concentration of N+ diffusion remnant layer and the N+ buffer layer is gradually increased outward from the border with the N- base layer. The N+ diffusion remnant layer is placed on the topside surface of IGBT, which improve the device surface impurity density, reducing the JFET region resistance, thus effectively reducing the on-state voltage drop of IGBT, while the forward blocking voltage is not sensitive to the thickness change of the N+ diffusion remnant layer within a certain range.

## Description

### Technical Field of the Invention

The present invention relates to a power device and its method of manufacturing, more specially relates to an insulated gate bipolar transistor (IGBT) and its method of manufacturing.

### Background of the Invention

Insulated gate bipolar transistor (IGBT) combines the advantages of the fast switching and low drive power of MOSFET with the advantages of the high current density bipolar operation that results in low conduction losses. Its outstanding performance makes it widely accepted as the preferred power switching devices in a variety of medium-frequency medium-power applications.

Depending on the different backside structure of IGBT, it can be broadly classified under two types: Punch-through IGBT (PT-IGBT) and Non-punch-through IGBT (NPT-IGBT). PT-IGBT is generally fabricated on the P + substrate with a thickness of hundreds of microns, the N+ buffer layer and the N- base region in turn formed in the substrate through the epitaxial growth, and then the topside structure of IGBT formed on the N- base layer. The forward blocking voltage of IGBT is mainly determined by the impurity density and thickness of N- base region. The higher the forward blocking voltage, the thicker N- base region is needed. The IGBT with over 1000V forward blocking voltage, for example, need the thickness of the N- base in more than 100um, which is very difficult for the growth of epitaxial, and the manufacturing cost is quite high. NPT-IGBT is fabricated on the hundreds of microns in thickness uniformly doped N- single crystal substrate, the one side of which is formed the topside structure of IGBT, and then grinding the other side of the substrate, thickness of the residual part is controlled to satisfy the forward blocking voltage and finally use the method of boron implantation to form the backside P+ anode (also called Collector). Compared with the manufacturing method of PT-IGBT, it does not need to form a thick epitaxial layer, suitable for manufacturing high forward blocking voltage IGBT, but the absence ofN+ buffer layer makes NPT-IGBT require thicker N-base layer in order to achieve the same forward blocking voltage, and thus the on-state voltage drop is also larger than PT-IGBT. Requirements for the manufacture of IGBT with about 1000~2000 V forward blocking voltage, the thickness of N- base layer is mostly more than 100 microns, fabricating devices in such a thin substrate is very difficult, and easy to cause silicon wafer increased breakage.

As described in Chinese Pat. No. CN00135808.1, a new structure of IGBT is shown in FIG. 1. Its composition includes the backside anode 10, the backside P+ anode region 11, N+ buffer layer 12, N- base region 13, gate oxide 14, gate electrode 15, N+ cathode district 16, cathode 17, and P-type base region 18. The manufacturing method is as follows: First, deep phosphorus diffusion is performed from both sides of the wafer, after the removal of the topside diffusion layer, the MOSFET cells are fabricated on the polished topside of the wafer, then the wafer is ground from the backside, the residual part of the diffusion layer is carefully controlled as N+ buffer layer, and then the boron is implanted into the backside of the buffer layer to form the backside P+ anode region, finally the anode region metallization to form anode. Such structure of IGBT both has the low on-state voltage drop of PT-IGBT and short switching time of NPT-IGBT. This invention proposes the new structure of IGBT and its method of manufacturing. This new structure, similar to the soft punch-through structure of ABB and light punch-through structure of Mitsubishi Electric Corporation can effectively reduce the power loss. But for the topside structure, the invention is still proposed by the traditional methods, failed to innovate.

Classification from the topside structure of IGBT, it can be divided into planar gate structure and trench gate structure. The fabrication process of planar gate structure is simple, but due to the presence of the parasitic JFET (Junction Field Effect Transistor) effects arising from the JFET resistance, its on-state voltage drop is higher than that of the trench gate IGBT, and the current density is also lower. To lower the JFET resistance, the usual way is to increase the doping concentration of topside surface, so that the surface resistivity decreases. The method is implantation (usually called JFET implantation) in whole or in part of surface before fabrication the general topside structure of planar gate IGBT, then diffused the impurity into a certain depth of the topside surface, which raise the surface doping concentration, accordingly the JFET resistance is decreased. However, due to the increase in the JFET implantation process, this method will inevitably cause rising the production costs, increasing the process discrete, and reducing the forward blocking voltage of IGBT.

The present invention proposes an insulated gate bipolar transistor and its manufacturing method, which can be overcome or mitigate these unfavorable factors, such as production costs rise, process discrete increase, forward blocking voltage decrease and so on, caused by the conventional planar gate IGBT manufacturing process due to the JFET implantation.

### Brief Description of the Invention

In accordance with the invention, the construction of IGBT consists of N-type base region, the P-type base region, back P-type anode region, N-type cathode region, the gate oxide layer, an anode, a gate electrode and a cathode. The N-type base region includes the N+ diffusion remnant layer, N- base layer and N+ buffer layer. The doping concentration of N+ diffusion remnant layer and the N+ buffer layer is gradually increased outward from the border with the N- base layer.

The abovementioned N- base layer has constant impurity density. Its thickness and impurity density is determined by the forward blocking voltage of the device required. Forward blocking voltage is positive correlation with the thickness of the N-base layer, negative correlation with the impurity density.

The abovementioned N+ buffer layer need appropriate thickness. Too thick will cause the on-state voltage drop increases, too thin will fail to stop the electric field in the N-type base region, which make the forward blocking voltage is reduced. The surface impurity density of N + buffer layer interface with back P-type anode is negatively correlated with the thickness of N+ buffer layer. The presence of the N+ buffer layer can be thinner to achieve the same forward blocking voltage, while the voltage drop will be lower.

The abovementioned N+ diffusion remnant layer also need appropriate thickness. Too thin will lead to low surface impurity density, which fail to reduce the JFET resistance effectively. While too thick will make surface impurity density higher, reducing the JFET resistance strongly, but will cause lower forward blocking voltage. Therefore the optimized thickness of N+ diffusion remnant layer is a few microns to more than ten microns.

The process for the manufacture of the IGBT is as follows:
(1) The first diffusion region and the second diffusion region are formed on both sides of the N-type silicon wafer by high-temperature ultra-deep diffusion;
(2) The first diffusion region and the second diffusion region are ground respectively to form N+ diffusion remnant layer and the N+ buffer layer;
(3) P-type base region, the N-type cathode region, the gate oxide layer, the cathode, the gate electrode are formed on the N+ diffusion remnant layer;
(4) Back P-type anode region is formed on the N+ buffer layer; the anode is formed after metallization on the back p-type anode region.

In accordance with the invention, due to its special method of manufacturing: an N+ diffusion remnant layer is retained on the N- base region to increase the surface impurity density so that the on-state voltage drop of IGBT reduce because of weakening the effect of JFET resistance. At the same time, compared with formation of similar abrupt and shallow junction structure using JFET implantation technology, the formation of N+ diffusion remnant layer similar to the linearly graded and deep junction structure, which is relatively small impact of the forward blocking voltage. Meanwhile, the junction depth of diffusion remnant layer is easy to control and the collector current and forward blocking voltage of the device is good stability because of the process.

In accordance with the invention, formation of N+ diffusion remnant layer just uses some normal processes such as high-temperature diffusion, grinding, polishing. No additional JFET implantation process will enable the total manufacturing costs decrease.

### Brief Description of the Drawings

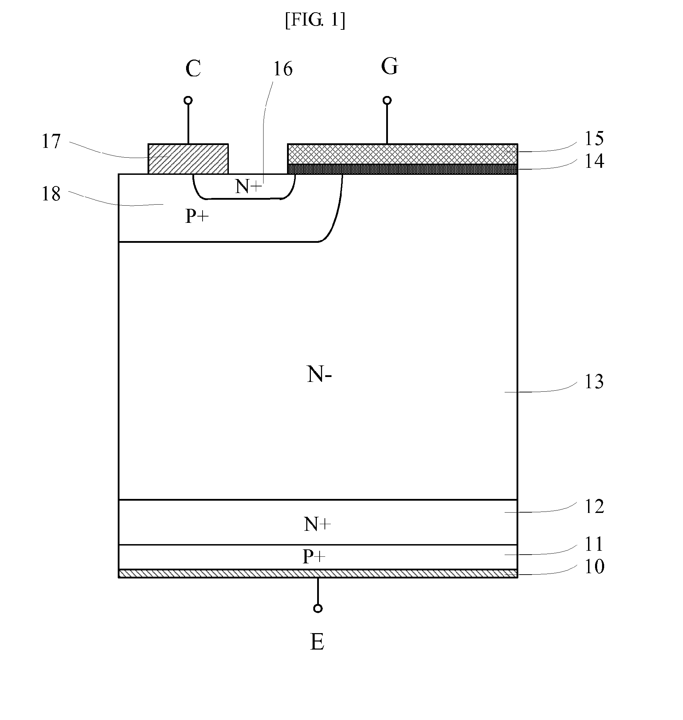

**FIG.1** schematically shows a cross-section of a small portion of a prior art type of IGBT.
**FIG. 2** schematically shows a cross-section of a small portion of the present invention IGBT.

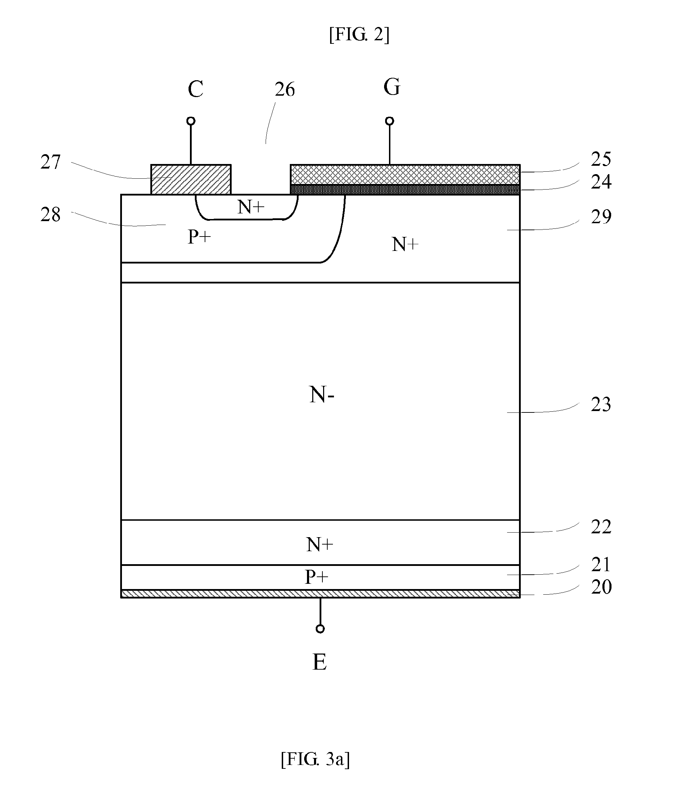

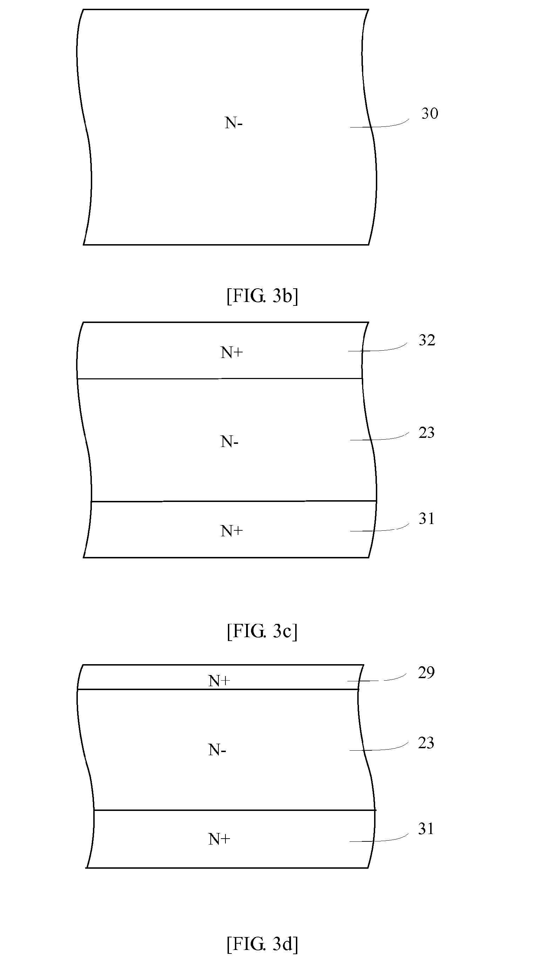

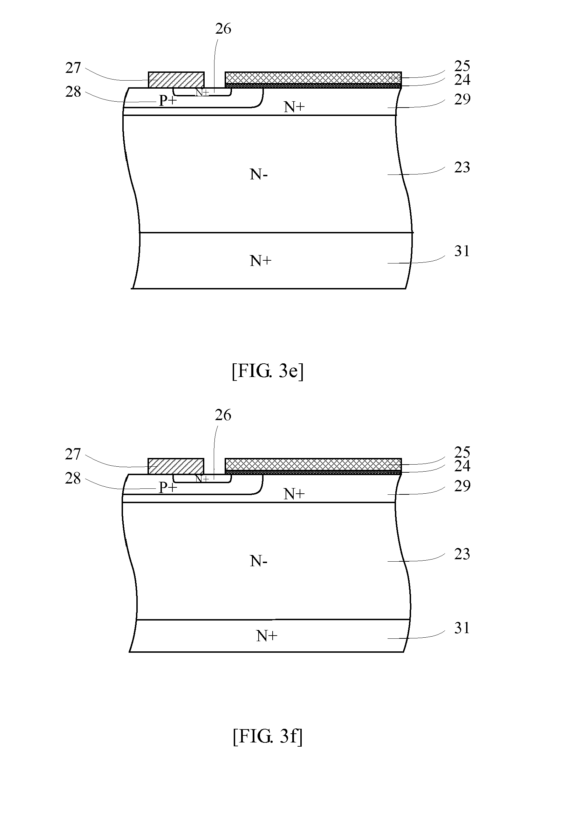

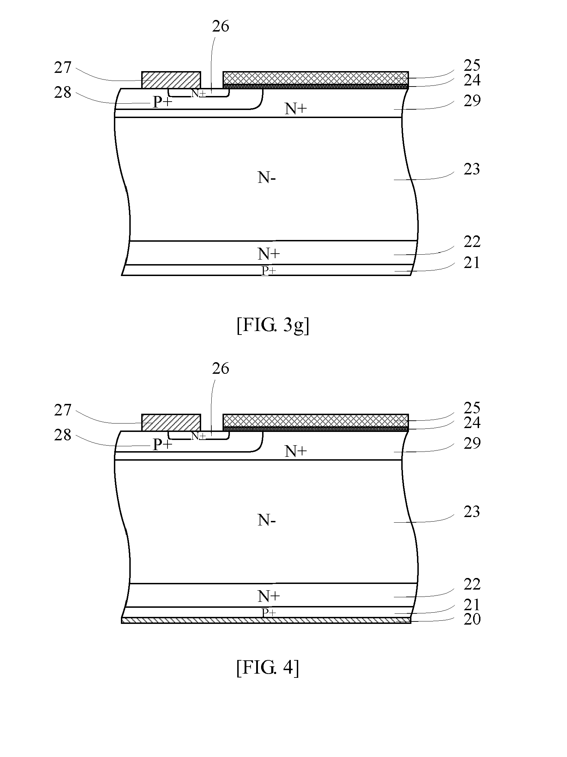

**FIG. 3** schematically shows a cross-section of a small portion of the formed the present structure of IGBT after the key steps of the manufacturing process. Among them, **FIG.3a** schematically shows a cross-section of a small portion of the N-type silicon wafer as the initial step of the manufacturing process; **FIG. 3b** schematically shows a cross-section of a small portion of the structure of **FIG. 3a** showing the formation two N+ diffusion layers after high temperature diffusion; **FIG. 3c** schematically shows a cross-section of a small portion of the structure of **FIG. 3b** following a grinding step for formation the diffusion remnant layer; **FIG. 3d** schematically shows a cross-section of a small portion of the structure of **FIG. 3c** after formation the topside MOS structure; **FIG. 3e** schematically shows a cross-section of a small portion of the structure of **FIG. 3d** showing the removal of part of N+ diffusion layer to form the N+ buffer layer; **FIG. 3f** schematically shows a cross-section of a small portion of the structure of **FIG. 3e** after boron implantation has been driven to form back P+ anode region; **FIG. 3g** schematically shows a cross-section of a small portion of the structure of **FIG. 3f** showing the metallization of back P+ anode region to form anode.
**FIG. 4** shows the impact of thickness of topside diffusion remnant layer on the on-state voltage drop and collector current.
**FIG. 5** shows the results of the collector current and the forward blocking voltage under the circumstances of using topside diffusion remnant layer process or the JFET implantation technology.

### Detailed Description of the Drawings

As shown in **FIG. 2**, an IGBT consists of the N-type base region, the P-type base region 28, back P+ anode region 21, N+ cathode region 26, gate oxide layer 24, cathode 27, the gate electrode 25 and the anode 20. The N-type base region includes the N+ diffusion remnant layer 29, N- base layer 23 and N+ buffer layer 22.

In order to form the abovementioned IGBT, the whole manufacturing process is shown in **FIG. 3****.** The following description of the preferred embodiments of the invention describes the manufacture of the IGBT. But it is noted that the figures do not show the specific process steps, but schematically shows the cross-section of a small portion of the device cell after the completion of these process steps. It should be further noted that the termination structure of the device is not shown in any figures, but the terminations commonly used for any IGBT device can also be used here.

**FIG. 3a** shows a wafer having an N- body 30 with the crystal orientation <100> monocrystalline silicon with its thickness of 500 microns and the impurity density of 6E13 cm⁻³. According to the forward blocking voltage (such as 1700 Volts, for example) of the ultimately formed IGBT, the chosen impurity density of wafer is from 2E13 cm⁻³ to 2E14 cm⁻³.

**FIG. 3b** shows the formation of the first N+ diffusion region 32 and the second N+ diffusion region 31 at both side of the N- base region through high-temperature ultra-deep diffusion. The thickness of N- base region is from 100 um to 250 um depending upon the forward blocking voltage of the ultimately formed device.

**FIG. 3c** shows the formation of the N+ diffusion remnant layer 29 by grinding and polishing the first N+ diffusion region 32. The N+ diffusion remnant layer is carefully controlled to keep a few microns. The whole thickness of the residual part of substrate is not less than 300 microns, in case cause wafer breakage at the following process.

Referring next to **FIG. 3d**, there is shown the completion of the topside MOS structure of IGBT. The Process includes the following steps: first on the N+ diffusion residual layer 29, through the steps of the P+ lithography, etching, boron implantation and annealed, the P-type base region 28 is formed, and then on its surface the gate oxide layer 24 is formed, on the gate oxide layer 24 the polysilicon is deposited to form the gate electrode 25, thereafter, the N+ cathode region 26 is formed through steps of N+ lithography, etching, arsenic implantation and annealed, and the last step is the deposition of metal on the N+ cathode region to form the cathode 27.

**FIG. 3e, 3f****,** and **3g** show the formation of N+ buffer layer 22, P+ anode region 21 and the anode 20 at the backside of the IGBT. **FIG. 3e** shows the second N+ diffusion region 31 is ground and polished to keep from 20 micron to 40 micron as N+ buffer layer 22, and then boron is implanted on the surface of N+ buffer layer and annealed forming P+ anode region 21, just as **FIG. 3f** shown, and finally the anode 20 formed by metallization shown in **FIG. 3g**.

**FIG. 4** shows under a determined area of device, the on-state voltage drop and collector current of the planar gate IGBT, which formed by the abovementioned embodiment fabrication method, change with the thickness of the topside diffusion remnant layer 29. In the figure, the two left-most points of the two curves, respectively, indicate the on-state voltage drop and collector current of the IGBT without remnant layer. It is the on-state voltage drop of 2.07 V and collector current of 74 A; and the IGBT with 6 micron remnant layer, its on-state voltage drop of 1.98 V, and collector current of 83 A. It can be seen from the data on the figure, the topside diffusion layer weaken the impact of the JFET resistance, which make the on-state voltage drop decrease, so that the collector current has increased significantly and effectively improved the performance of the device. At the same time, duo to no longer in use the JFET implant, the manufacturing costs have been reduced.

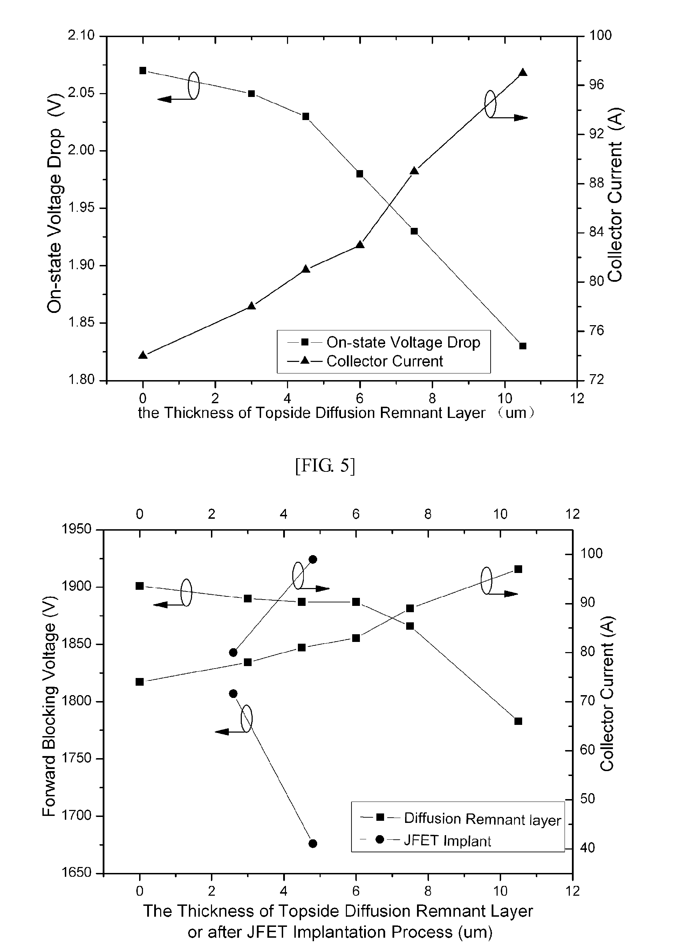

On the other hand, the abovementioned N+ diffusion remnant layer of IGBT on the N- base region is linearly graded and deep junction structure, which is relatively small impact on the forward blocking voltage of device compared to the conventional JFET implantation technology by which form abrupt and shallow junction structure. It can be seen from **FIG. 5**, increasing the same collector current, the forward blocking voltage of device which use diffusion remnant technology reduces much smaller than that of device using JFET implantation technology. Moreover, the controllability and stability of the diffusion remnant technology is also better than that of the JFET implantation technology. The fluctuations of the thickness of diffusion remnant layer less affect on the collector current and forward blocking voltage.

## Claims

1. An IGBT comprising: the N-type base region, the P-type base region, back P+ anode region, N+ cathode region, gate oxide layer, cathode, the gate electrode and the anode. The N-type base region includes the N+ diffusion remnant layer, N- base layer and N+ buffer layer. The doping concentration of N+ diffusion remnant layer and the N+ buffer layer is gradually increased outward from the border with the N- base layer.

2. The IGBT as claimed in claim 1, wherein the thickness of N+ diffusion remnant layer is micron magnitude. The PN junction formed by the P-type base region has a linearly graded junction structure.

3. The IGBT as claimed in claim 1 and claim 2, wherein the N+ diffusion remnant layer is retained by grinding after high-temperature ultra-deep diffusion. The PN junction formed by the P-type base region has a deep junction structure.

4. The IGBT as claimed in claim 1, claim 2 and claim 3, wherein the process for the manufacture of the IGBT; said process comprising the steps of:
(1) The first diffusion region and the second diffusion region are formed on both sides of the N-type monocrystalline silicon wafer by high-temperature ultra-deep diffusion;
(2) The first diffusion region and the second diffusion region are ground respectively to form N+ diffusion remnant layer and the N+ buffer layer;
(3) P-type base region, the N-type cathode region, the gate oxide layer, the cathode, the gate electrode are formed on the N+ diffusion remnant layer;
(4) Back P-type anode region is formed on the N+ buffer layer; the anode is formed after metallization on the back P-type anode region.
5. The process for the manufacture of the IGBT as claimed in claim 4, wherein the N+ diffusion remnant layer are formed by grinding the first diffusion region.
